# EUROPEAN PATENT APPLICATION

(11) **EP 1 434 254 A2**
(43) Date of publication of application: **30.06.2004**
(21) Application number: 03029174.4
(22) Date of filing: 18.12.2003
(51) Int. Cl.: H01L 21/00, H01L 21/306, C30B 25/02

(54) **Processing apparatus**

(30) Priority: 26.12.2002 JP 2002378685; 26.12.2002 JP 2002378686
(71) Applicant: CANON KABUSHIKI KAISHA, Tokyo (JP)
(72) Inventor: Tsuboi, Takashi, Tokyo (JP); Yamagata, Kenji, Tokyo (JP); Sakaguchi, Kiyofumi, Tokyo (JP); Yanagita, Kazutaka, Tokyo (JP); Sugai, Takashi, Tokyo (JP); Takanashi, Kazuhito, Tokyo (JP)
(74) Representative: Leson, Thomas Johannes Alois, Dipl.-Ing.

(57) **Abstract**

Openings are formed at the bottom of an anodizing container. A shower-type current path forming mechanism is arranged at the lower portion of the anodizing container. The mechanism has a pressure vessel. A shower head is arranged at the upper portion of the pressure vessel. A conductive solution in a shower form is injected or discharged from the shower head to form a liquid electrode under the lower surface of a substrate. Accordingly, a current flows between a cathode and an anode to anodize the substrate. The apparatus also has a mechanism which makes a chemical solution overflow from a chemical solution container to form a flow of the chemical solution near the lower surface of the substrate.

## Description

### FIELD OF THE INVENTION

The present invention relates to a processing apparatus that can suitably be used for a process such as anodizing.

### BACKGROUND OF THE INVENTION

Japanese Patent Laid-Open Nos. 5-21338 and 7-302889 disclose methods of manufacturing a SOI (Silicon On Insulator or Semiconductor On Insulator) substrate, in which a first substrate (seed wafer) and a second substrate (handle wafer) are bonded to prepare a bonded substrate stack (connected substrate) as an intermediate substrate, and the bonded substrate stack is separated to form an SOI substrate. In this SOI substrate manufacturing step, an anodizing apparatus can be used, which anodizes the first substrate to form a porous layer on its surface.

An anodizing apparatus generally has a cathode and anode in an anodizing container. The anodizing container is filled with an electrolyte. A substrate is arranged between the cathode and the anode, and a current is supplied between them, thereby executing anodizing. Such anodizing apparatuses are disclosed in Japanese Patent Laid-Open Nos. 10-275798, 11-195639, 11-214353, 11-195640, 2000-336499, 2000-277484, and 2000-273699. In these anodizing apparatuses, and especially, in an arrangement which horizontally sets a substrate, chemical failure (e.g., failure in thickness distribution of the resultant porous layer) may occur due to accumulations of bubbles under the lower surface of the substrate.

An anodizing apparatus which solves the problem of the accumulations of bubbles under the lower surface of a substrate is disclosed in Japanese Patent Laid-Open No. 2000-277478. This apparatus uses a solid electrode and processes a substrate while keeping the solid electrode in contact with the lower surface of the substrate.

However, the solid electrode may cause damage such as flaws or the like to the lower surface of the substrate. In this point, the arrangement which fills the space between the substrate lower surface and the electrode with a conductive chemical solution (e.g., an electrolyte) is more advantageous. For example, Japanese Patent Laid-Open No. 6-216110 discloses an apparatus which overflows an electrolyte solution while supplying it. However, when a substrate in a horizontal state is to be processed, it is difficult to form a flow along the processed surface of the substrate. More specifically, in the method that brings a conductive chemical solution into contact with the lower surface of a substrate, bubbles accumulate under the lower surface of the substrate. In the method that brings a solid electrode into contact with the lower surface of a substrate, the lower surface of the substrate may be damaged or form flaws or the like.

Especially, substrates are often processed or manipulated in a horizontal state in recent years. To facilitate substrate transport between apparatuses, an anodizing apparatus also preferably processes substrates in the horizontal state.

### SUMMARY OF THE INVENTION

The present invention has been made in consideration of the above situation, and has as its object to provide a processing apparatus which hardly causes any damage such as flaws or the like of a substrate, reduces process failure due to bubbles, and can suitably be used for an application example in which a substrate is processed horizontally.

A processing apparatus according to the present invention is a processing apparatus which has a first electrode and a second electrode, arranges a substrate between the first and second electrodes, and supplies a current between the first and second electrodes through a chemical solution and the substrate to process the substrate. The processing apparatus comprises a shower head which is arranged between the first electrode and the substrate to form a chemical solution flow in a shower form toward the substrate, wherein the chemical solution flow in the shower form formed by the shower head forms part of a current path between the first and second electrodes.

The processing apparatus of the present invention may have another shower head. More specifically, the processing apparatus of the present invention may further comprise another shower head which is arranged between the second electrode and the substrate to form a chemical solution flow in a shower form toward the substrate. In this case, the chemical solution flow in the shower form formed by the two shower heads forms part of a current path between the first and second electrodes.

According to a preferred embodiment of the present invention, preferably, the shower head has a member having a plurality of openings, and the chemical solution in the shower form is injected or discharged through the plurality of openings.

According to another preferred embodiment of the present invention, a surface of the member, which has the plurality of openings, is preferably arranged substantially parallel to the substrate.

According to still another preferred embodiment of the present invention, the processing apparatus of the present invention preferably further comprises a circulation mechanism which recovers the chemical solution injected or discharged from the shower head and supplies the chemical solution again to the shower head.

According to another aspect of the present invention, there is provided a processing method of arranging a substrate between a first electrode and a second electrode and supplying a current between the first and second electrodes through a chemical solution and the substrate to process the substrate. The method comprises a step of arranging a shower head at least at one of a position between the first electrode and the substrate and a position between the second electrode and the substrate, causing the shower head to form a chemical solution flow in a shower form toward the substrate, and causing the chemical solution flow in the shower form to form part of a current path between the first and second electrodes.

According to still another aspect of the present invention, there is provided an anodizing method of arranging a substrate between a first electrode and a second electrode and supplying a current between the first and second electrodes through a chemical solution and the substrate to anodize the substrate. The method comprises a step of arranging a shower head at least at one of a position between the first electrode and the substrate and a position between the second electrode and the substrate, causing the shower head to form a chemical solution flow in a shower form toward the substrate, and causing the chemical solution flow in the shower form to form part of a current path between the first and second electrodes.

A processing apparatus according to the present invention is a processing apparatus which has a first electrode arranged above a substrate to oppose the substrate and a second electrode arranged under the substrate to oppose the substrate and executes a chemical process for the substrate. The processing apparatus comprises a chemical solution container which fills a space between the substrate and the second electrode with a chemical solution, and a mechanism which forms a flow of the chemical solution near a lower surface of the substrate, wherein the mechanism has a function of causing the chemical solution to overflow from the chemical solution container.

According to a preferred embodiment of the present invention, the chemical solution container is preferably configured to bring the chemical solution into contact with the lower surface of the substrate.

According to another preferred embodiment of the present invention, preferably, the chemical solution container has a plate which has one or a plurality of openings and opposes the substrate, and the chemical solution flows toward the substrate through the openings of the plate.

According to still another preferred embodiment of the present invention, the plate is preferably arranged at an upper portion of the chemical solution container.

According to still another preferred embodiment of the present invention, preferably, the second electrode has one or a plurality of openings, and the chemical solution flows toward the substrate through the openings of the second electrode.

According to still another preferred embodiment of the present invention, the second electrode having the openings is preferably arranged at an upper portion of the chemical solution container.

According to still another preferred embodiment of the present invention, the apparatus preferably further comprises a holding portion which supports an outer peripheral wall portion of the substrate.

According to still another preferred embodiment of the present invention, a diameter of a cross-section of the chemical solution container near the substrate is preferably substantially the same as that of the substrate.

According to still another preferred embodiment of the present invention, the chemical solution container preferably has an overflow container to be filled with the chemical solution on its outer side.

A semiconductor substrate manufacturing method according to the present invention comprises steps of anodizing a first substrate in accordance with the above-described anodizing method to form a porous layer, forming a non-porous layer on the porous layer, bonding the first substrate having the non-porous layer to a second substrate via an insulating layer to prepare a bonded substrate stack, and processing or fabricating the bonded substrate stack to obtain a state in which the porous layer at least partially remains on the second substrate.

Another semiconductor substrate manufacturing method according to the present invention comprises anodizing a first substrate by using the afore-described processing apparatus to form a porous layer, forming a non-porous layer on the porous layer, bonding the first substrate having the non-porous layer to a second substrate via an insulating layer to prepare a bonded substrate stack, and processing or fabricating the bonded substrate stack to obtain a state in which the porous layer at least partially remains on the second substrate.

Other features and advantages of the present invention will be apparent from the following description taken in conjunction with the accompanying drawings, in which like reference characters designate the same or similar parts throughout the figures thereof.

### BRIEF DESCRIPTION OF THE DRAWINGS

The accompanying drawings, which are incorporated in and constitute a part of the specification, illustrate embodiments of the invention and, together with the description, serve to explain the principles of the invention.
Fig. 1 is a schematic view of a processing apparatus according to the first embodiment of the present invention, which can suitably be used as an anodizing apparatus;
Fig. 2 is a schematic view of a processing apparatus according to the second embodiment of the present invention, which can suitably be used as an anodizing apparatus;
Fig. 3 is a schematic view of a processing apparatus according to the third embodiment of the present invention, which can suitably be used as an anodizing apparatus;
Fig. 4 is a schematic view of a processing apparatus according to the fourth embodiment of the present invention, which can suitably be used as an anodizing apparatus;
Fig. 5 is a schematic view of a processing apparatus according to the fifth embodiment of the present invention, which can suitably be used as an anodizing apparatus;
Fig. 6 is a schematic view of a processing apparatus according to the sixth embodiment of the present invention, which can suitably be used as an anodizing apparatus; and
Figs. 7A to 7E are views for explaining a semiconductor substrate manufacturing method according to a preferred embodiment of the present invention.

### DETAILED DESCRIPTION OF THE PREFERRED EMBODIMENTS

The preferred embodiments of the present invention will be described below with reference to the accompanying drawings.

### [First Embodiment]

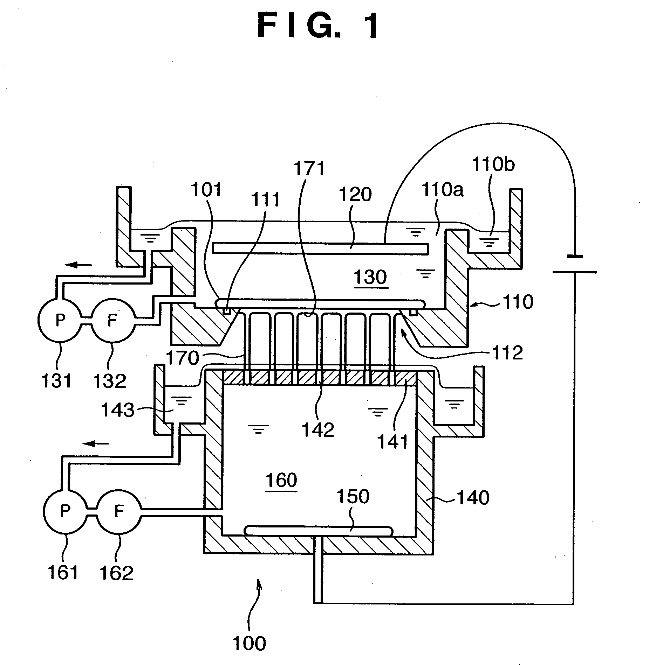

Fig. 1 is a view showing the schematic arrangement of an anodizing apparatus (processing apparatus) according to a preferred embodiment of the present invention. An anodizing apparatus 100 shown in Fig. 1 horizontally holds and processes a substrate 101 to be processed. Horizontally holding and processing the substrate is advantageous because, e.g., the substrate need not be turned when it is transferred to/from another apparatus that horizontally holds and processes or manipulates (e.g., transports) the substrate. However, the present invention can also be applied to an apparatus that processes a substrate held not horizontally but in another direction (e.g., vertical direction).

The substrate 101 to be processed is horizontally held at the bottom of an anodizing container 110. The surface of the substrate 101 is turned up. The anodizing container 110 has, at its bottom, e.g., an annular suction groove (suction mechanism) to vacuum-chuck the substrate as a holding mechanism 111 that holds the substrate 101. A cathode (second electrode) 120 is arranged above the substrate 101 held by the holding mechanism 111. The anodizing apparatus 100 has a cathode driving mechanism (not shown) which moves the cathode 120. When the substrate 101 is set at the bottom of the anodizing container 110 or when the processed substrate 101 is taken out from the bottom of the anodizing container 110, the cathode 120 is moved by the cathode driving mechanism to such a position that the cathode 120 does not interfere with manipulation of the substrate 101.

The anodizing container 110 can be constructed as an overflow-type container having, e.g., a main body container 110a and overflow container 110b. The anodizing container 110 is filled to a predetermined level (i.e., the upper edge of the main body container 110a) with a process solution for anodizing, i.e., a chemical solution (chemical solution) 130. The process solution 130 that has overflowed from the main body container 110a is recovered by the overflow container 110b. The process solution 130 is then returned to the main body container 110a through a pump 131 and filter 132. That is, in this embodiment, a circulation system is formed for the process solution 130. The process solution (chemical solution) 130 is a liquid containing, e.g., hydrogen fluoride (HF).

The cathode 120 is preferably made of a material (e.g., platinum) having a high corrosion resistance or a material (e.g., the same material as that of the substrate 101) that rarely contaminates the substrate 101 to be processed. Typically, the substrate 101 is a silicon substrate, and the process solution 130 contains hydrogen fluoride. Hence, the cathode 120 is preferably made of platinum that has a high corrosion resistance against hydrofluoric acid or silicon, i.e., the same material as that of the substrate 101.

The anodizing container 110 has openings 112 at the bottom. The lower surface of the substrate 101 held at the bottom is exposed downward through the openings 112. The openings 112 are used to form a current path through the substrate 101, as will be described later.

A shower-type current path forming mechanism is employed on the lower surface side of the substrate 101. The current path forming mechanism has a pressure vessel (conductive solution container) 140. The pressure vessel 140 has a shower head (shower forming member) 141 at the upper portion, i.e., a portion opposing the bottom of the anodizing container 110. The shower head 141 has a plurality of openings 142. A conductive solution (second chemical solution) 160 to form a current path is injected or discharged in a shower form toward the lower surface of the substrate 101 through the openings 142.

Injection of the conductive solution 160 from the shower head 141 is preferably set such that the conductive solution 160 spreads along the lower surface of the substrate 101 to form a liquid electrode 171 that covers the lower surface of the substrate 101. This setting depends on, e.g., the size of each opening 142, the array interval (pitch) between the plurality of openings 142, the pressure applied to the conductive solution 160, and the interval between the lower surface of the substrate and the shower head 141. The diameter of each opening 142 is preferably, e.g., about 0.1 to 1 mm. The array interval (pitch) between the openings 142 is preferably, e.g., 2 to 5 mm. The interval between the lower surface of the substrate and the shower head 141 is preferably, e.g., 2 to 100 mm. The shower head 141 is typically arranged almost parallel to the substrate 101.

The conductive solution 160 injected from the shower head 141 is recovered by a recovery container 143. The conductive solution 160 recovered by the recovery container 143 is returned to the pressure vessel 140 through a pump 161 and filter 162. At this time, for example, the pump 161 may apply a pressure necessary for jet formation to the conductive solution 160 in the pressure vessel 140. Such a pressure can be applied by various methods. For example, the pressure may be applied by using the difference of elevation, which is obtained by pumping up the conductive solution to a predetermined level with a pump, or by changing the volume of the pressure vessel 140. Any other known pressure application methods can be employed.

To supply a current having a desired current value through the substrate 101, a voltage higher than that applied to the cathode 120 is applied to the conductive solution 160. For example, in this embodiment, an anode (first electrode) 150 is arranged in the pressure vessel 140. A potential difference is given between the anode 150 and the cathode. Potential application to the conductive solution 160 can be implemented either by, e.g., forming an anode entirely or partially on the inner wall of the pressure vessel 140 or by using the shower head 141 as an anode.

As the conductive solution 160, any conductive liquid (e.g., an electrolyte such as hydrofluoric acid) can be used. The concentration, composition, and properties of the conductive solution 160 may be the same as or different from those of the process solution 130.

The anode 150 is preferably made of a material (e.g., platinum) having a high corrosion resistance or a material (e.g., the same material as that of the substrate 101) that rarely contaminates the substrate 101 to be processed. Typically, the substrate 101 is a silicon substrate, and the process solution 130 and conductive solution 160 contain hydrogen fluoride. Hence, the anode 150 is preferably made of platinum that has a high corrosion resistance against hydrofluoric acid or silicon, i.e., the same material as that of the substrate 101.

As described above, the liquid electrode 171 is formed under the lower surface of the substrate 101 by the flow of the conductive solution 160 in a shower form. The liquid electrode 171 forms part of the current path (the current path between the cathode 120 and the anode 150) passing through the substrate 101. Accordingly, any anodizing failure (e.g., failure in thickness distribution of the porous layer) due to accumulation of bubbles under the lower surface of the substrate can be prevented. The liquid electrode 171 is maintained by the flow of the conductive solution 160 that is continuously supplied in a shower form. For this reason, even when bubbles are formed in the liquid electrode 171, they are quickly removed.

According to this embodiment, anodizing failure can be reduced, and the reproducibility between substrates can be increased.

### [Second Embodiment]

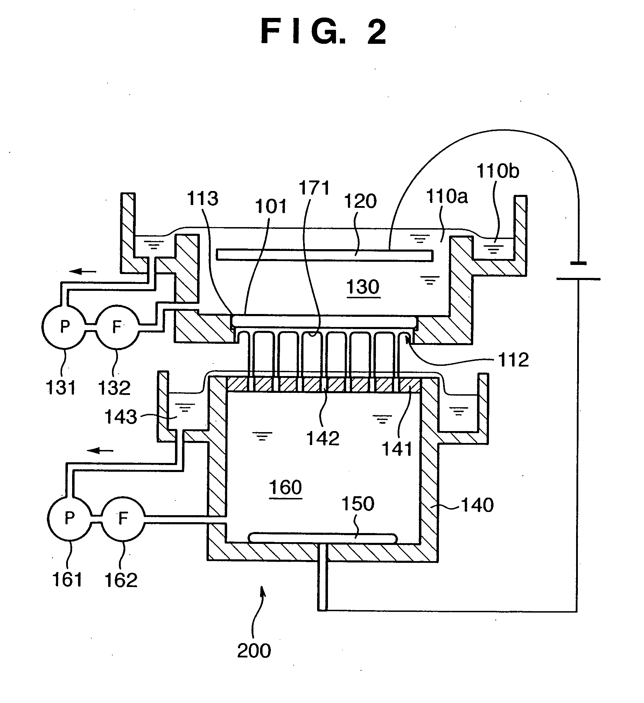

Fig. 2 is a view showing the schematic arrangement of an anodizing apparatus as a modification of the anodizing apparatus shown in Fig. 1. An anodizing apparatus 200 shown in Fig. 2 is different from the anodizing apparatus 100 shown in Fig. 1 in the substrate holding mechanism. More specifically, the anodizing apparatus 200 shown in Fig. 2 is different from the anodizing apparatus 100 shown in Fig. 1 in that the anodizing apparatus 200 has an edge holding mechanism 113 which holds a substrate 101 only at or near its edge portion.

The above description is related to a detailed example in which the present invention is constituted as an anodizing apparatus. However, the present invention can also be applied to another processing such as plating.

The apparatus shown in Fig. 1 or 2 has a shower-type current path forming mechanism on only the lower surface side of the substrate. Such a current path forming mechanism can be applied either to only the surface substrate side of the substrate or to the both sides of the substrate.

### [Third Embodiment]

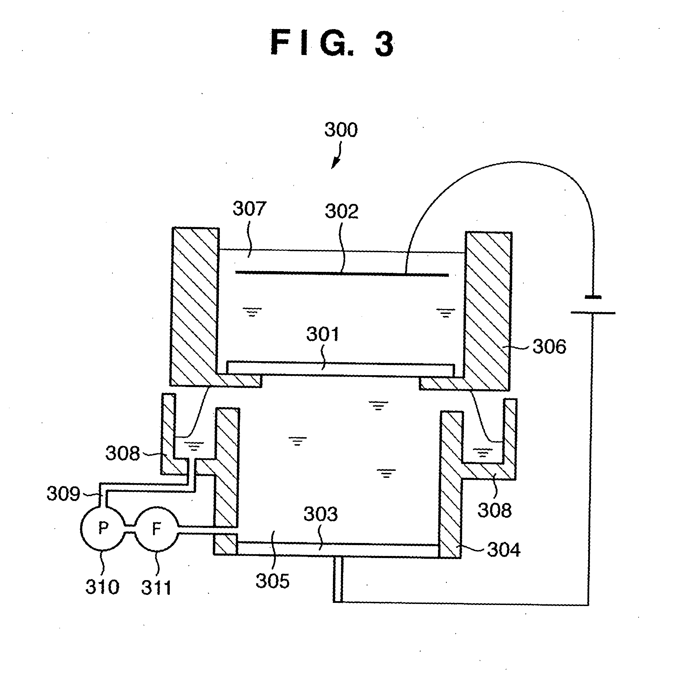

Fig. 3 is a view showing a processing apparatus 300 according to the third embodiment of the present invention. The processing apparatus 300 comprises a cathode 302, anode 303, chemical solution container 304, and a flow forming mechanism. The cathode 302 serving as a first electrode is arranged above and opposes an Si wafer 301 as a substrate to be processed. The anode 303 serving as a second electrode is arranged under and opposes the Si wafer 301. The chemical solution container 304 fills the space between the Si wafer 301 and the anode 303 with a chemical solution 305. The flow forming mechanism forms a flow of the chemical solution 305 near the lower surface of the Si wafer 301. The flow forming mechanism includes a function of overflowing the chemical solution 305 from the chemical solution container 304.

As the flow forming mechanism that forms a flow of the chemical solution 305 near the lower surface of the Si wafer 301, a mechanism such as a pump 310 which moves a liquid can be used. However, the present invention is not limited to this. The mechanism that moves a liquid may form a flow of the chemical solution 305 by, e.g., using a gas pressure or a pressure by gravity (difference of elevation of liquid). The pump 310 that is exemplified as the flow forming mechanism can take various forms to form a flow of the chemical solution 305 near the lower surface of the Si wafer 301. This will be described later.

The processing apparatus 300 according to the preferred embodiment of the present invention can be applied to various processes for a substrate. In the present invention, a case wherein the apparatus is applied to an anodizing apparatus will be described as an example.

Referring to Fig. 3, the Si wafer 301 is an example of a substrate to be processed by a chemical process. For example, single-crystal silicon is used. When the Si wafer 301 is to be subjected to a chemical process (e.g., anodizing), a chemical container 306 is filled with a chemical solution 307. In this state, the cathode 302 is dipped in the chemical solution 307 and made to oppose the Si wafer 301. In addition, the anode 303 is arranged under the Si wafer 301. In this embodiment, the Si wafer 301 is anodized to form porous silicon on the surface of the wafer. As is known, when the Si wafer 301 is anodized by using a liquid contact type processing apparatus, hydrogen is generated from the upper and lower surfaces of the Si wafer 301. After anodizing, a porous layer is formed on the upper surface of the Si wafer 301 so that the upper surface structure changes. However, the structure of the lower surface does not actually change.

The cathode 302 is preferably made of a material having a resistance against the process solution for the chemical process. For example, when an HF solution is employed as the process solution for the chemical process, the cathode 302 is preferably made of platinum, i.e., a material having a resistance against HF.

When, e.g., DHF (diluted hydrofluoric acid) is employed as the conductive solution, the anode 303 is preferably made of platinum, i.e., a material having a resistance against HF. The anode 303 may be made of the same silicon material as that of the Si wafer 301. The silicon material preferably has a low resistivity. When the anode 303 is made of the silicon material, contamination of the Si wafer 301 by the material of the anode 303 can be prevented.

The space in the chemical solution container 304 under the lower surface of the Si wafer 301 is filled with the conductive chemical solution 305 (conductive solution) to keep electrical contact. As described above, the chemical solution container 304 has an arrangement that forms a flow of the chemical solution 305 near the lower surface of the Si wafer 301. As such an arrangement, for example, the chemical solution container 304 has a pump. The inlet and outlet of the pump 310 are preferably arranged at the upper portion of the chemical solution container 304, or they are arranged respectively at the upper and lower portions of the chemical solution container 304, shown in Fig. 3, such that the flow of the chemical solution 305 is formed near the lower surface of the Si wafer 301. The positions of the inlet and outlet of the pump 310 are not limited to the example shown in Fig. 3, and various forms can be used. For example, the inlet and outlet of the pump 310 may be arranged on the opposite side to those in Fig. 3.

The chemical solution container 304 preferably has on its outer side an overflow container 308 that is filled with the chemical solution 305 that has overflowed from the chemical solution container 304. The overflow container 308 is preferably connected to the chemical solution container 304 through a connection channel 309, as shown in Fig. 3. The connection channel 309 preferably has a filter 311 that removes particles in the chemical solution 305.

The chemical solution container 304 is designed to make the chemical solution 305 overflow to form a flow of the chemical solution 305 near the lower surface of the Si wafer 301. In this case, for example, an interval may be ensured between the chemical solution container 304 and the Si wafer 301 to make the chemical solution 305 overflow from the chemical solution container 304, as shown in Fig. 3. This interval is not particularly limited, and for example, can be 2 to 8 mm. When the chemical solution 305 should overflow, it is brought into contact with the lower surface of the Si wafer 301 to obtain satisfactory electrical contact to this surface.

The chemical solution 305 is a conductive chemical solution (conductive solution). In this embodiment, for example, DHF (diluted hydrofluoric acid) is used. However, the present invention is not limited to this. Any other conductive solution may be used.

The chemical container 306 is preferably made of a material having a resistance against the process solution for the chemical process. For example, when an HF solution is employed as the process solution for the chemical process, the chemical container 306 is preferably made of polytetrafluoroethylene (Teflon (registered trademark)), i.e., a material having a resistance against HF.

As the chemical solution 307, an arbitrary process solution that processes the substrate to be processed can be employed. For example, for anodizing, an HF solution can be used as the chemical solution 307, i.e., the process solution for anodizing.

In this embodiment, the cathode 302 is arranged above the Si wafer 301, and the anode 303 is arranged under the Si wafer 301. However, the present invention is not limited to this. For example, the cathode 302 may be arranged under the Si wafer 301, and the anode 303 may be arranged above the Si wafer 301. In this case, when it is assumed that the processing apparatus 300 is applied to an anodizing apparatus, the above-described arrangement is changed in the following way. That is, for example, an HF solution is used as the process solution for the chemical process on the cathode side. On the anode side, DHF (diluted hydrofluoric acid) is used as the conductive solution.

In this embodiment, in chemically processing the Si wafer 301, a flow of the chemical solution 305 is formed near the lower surface of the Si wafer 301. As the flow forming mechanism that forms the flow, an arbitrary mechanism is used. A flow forming mechanism which can obtain satisfactory contact with the lower surface of the Si wafer 301 and effectively remove a gas generated from the lower surface of the Si wafer 301 during the chemical process is preferably employed. As such a flow forming mechanism, for example, the pump 310 which supplies the chemical solution 305 can be used.

When the chemical solution 305 overflows, the flow of the chemical solution 305 can more effectively be formed near the lower surface of the Si wafer 301. The level of the overflowing chemical solution 305 is higher than the chemical solution container 304. Hence, the chemical solution container 304 is preferably designed to bring the entire lower surface of the Si wafer 301 into contact with the chemical solution 305 by using the difference between the raised level and the upper edge of the chemical solution container 304. With this arrangement, a current can easily be supplied at the time of chemical process. The overflow acts to prevent any bubbles from remaining under the lower surface of the Si wafer 301 during introduction of the chemical solution 305. If a gas is generated under the lower surface of the Si wafer 301 during the chemical process, the overflow acts to efficiently remove the gas.

The pump 310 acts to supply the chemical solution 305 in the overflow container 308 to the chemical solution container 304 through the connection channel 309 formed between the overflow container 308 and the chemical solution container 304. The filter 311 inserted in the connection channel 309 acts to remove contaminants such as particles and keep the chemical solution 305 free from the contaminants.

As described above, according to this embodiment, a gas that is present in the undipped portion under the lower surface of the Si wafer or a gas generated during the chemical process can efficiently be removed by the flow forming mechanism that forms a chemical solution flow near the lower surface of the Si wafer. For this reason, satisfactory electrical contact can be obtained between the Si wafer and the chemical solution.

Hence, problems (e.g., a variation in thickness distribution of the film formed by anodizing or a decrease in reproducibility of the chemical process) posed by contact failure of the lower surface of the Si wafer due to the gas can be solved, and the chemical process can satisfactorily be executed.

When the chemical solution is caused to overflow, the level of the chemical solution rises. Hence, the above effects for ensuring electrical contact to the lower surface of the Si wafer and removing the gas can be more conspicuous.

When an overflow container is arranged outside the chemical solution container, the chemical solution that has overflowed from the chemical solution container can be recovered and reused. When a filter is inserted between the overflow container and the chemical solution container, the chemical solution can repeatedly be used.

### [Fourth Embodiment]

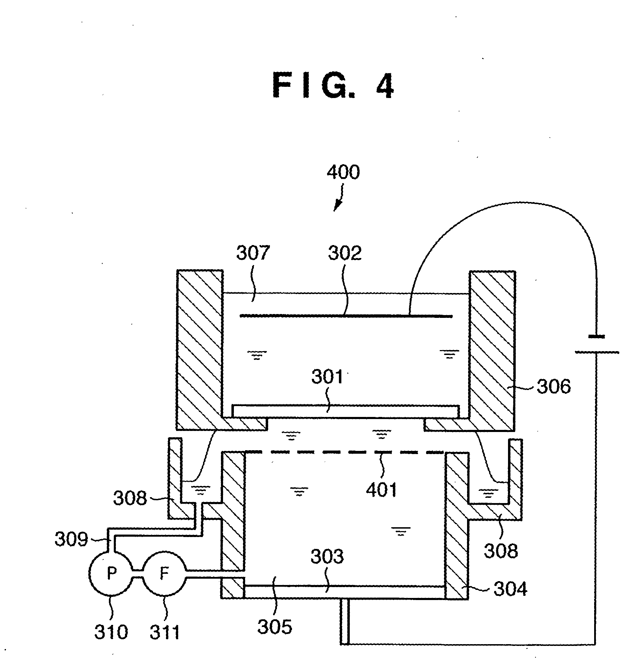

A processing apparatus according to the fourth embodiment of the present invention will be described below. Fig. 4 is a view showing the schematic arrangement of a processing apparatus 400 according to the fourth embodiment of the present invention. The processing apparatus 400 almost has an arrangement obtained by adding some functions to that of the processing apparatus 100 according to the first embodiment. More specifically, to more effectively form a flow of a chemical solution 305 in a chemical solution container 304 near the low surface of an Si wafer 301, the processing apparatus 400 has a plate 401 (to be referred to as a "punching plate" hereinafter), which has one or a plurality of openings and opposes the Si wafer 301, in addition to the arrangement of the processing apparatus 300 according to the third embodiment. The chemical solution 305 flows toward the Si wafer 301 through the openings of the punching plate 401. As shown in Fig. 4, the punching plate 401 is preferably arranged at the upper portion of the chemical solution container 304. However, the position is not limited to this, and various positions can be employed.

In this embodiment, the punching plate 401 acts to increase, of the flow of the chemical solution 305 in the chemical solution container 304, the flow in a direction almost perpendicular to the Si wafer 301. As such a mechanism, an arbitrary mechanism can be used. When the punching plate 401 is used, the opening distribution can be either uniform or nonuniform. The size or shape of each opening is not limited, either. The diameter of each opening of the punching plate 401 is not particularly limited, and for example, can be 5 to 10 mm. The interval between the openings of the punching plate 401 is not particularly limited, and for example, can be 10 to 30 mm.

As described above, according to this embodiment, of the flow of the chemical solution 305 in the chemical solution container 304, the flow in the direction almost perpendicular to the Si wafer 301 can be increased by the mechanism such as the punching plate 401. Since more satisfactory contact can be ensured between the chemical solution 305 and the lower surface of the Si wafer 301, the gas that exists under the lower surface of the Si wafer 301 can more efficiently be removed. When the punching plate 401 is arranged at the upper portion of the chemical solution container 304, this effect becomes conspicuous.

### [Fifth Embodiment]

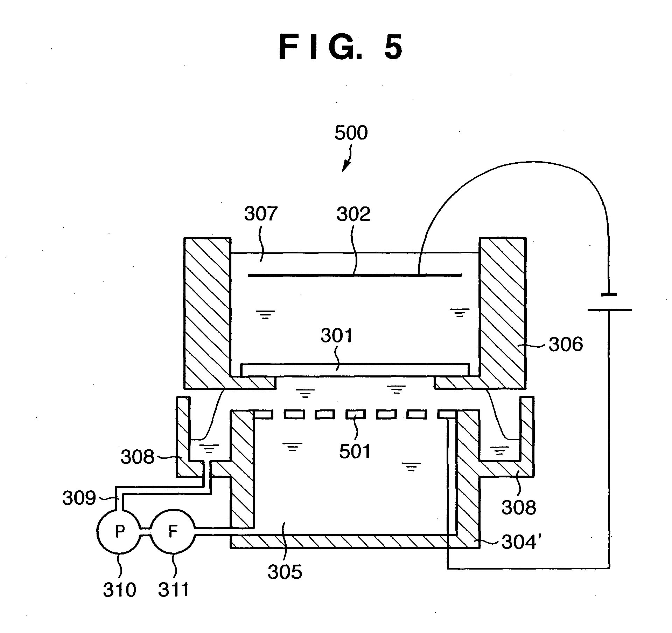

A processing apparatus according to the fifth embodiment of the present invention will be described below. Fig. 5 is a view showing the arrangement of a processing apparatus 500 according to the fifth embodiment of the present invention. The processing apparatus 500 almost has an arrangement obtained by adding some functions to that of the processing apparatus 300 according to the third embodiment. More specifically, to reduce the voltage to be applied between a cathode 302 and an anode 303, the processing apparatus 500 uses an anode 501 having one or a plurality of openings in place of the anode 303 of the processing apparatus 300 according to the third embodiment. A chemical solution 305 flows toward an Si wafer 301 through the openings of the anode 501. As shown in Fig. 5, the anode 501 is preferably arranged at the upper portion of a chemical solution container 304'. However, the position is not limited to this, and various positions can be employed.

In this embodiment, the anode 501 has one or a plurality of openings. For this reason, it has the same function as that of the punching plate 401 described in the fourth embodiment and can be arranged near the Si wafer 301. Hence, the voltage to be applied between the cathode 302 and the anode 501 becomes lower than that to be applied between the cathode 302 and the anode 303 in the processing apparatus 300 according to the third embodiment. In addition, the anode 501 provides the same effect as that of the punching plate 401 described in the fourth embodiment. Since the punching plate 401 need not be used, the number of components decreases to result in size reduction of the apparatus.

As described above, according to this embodiment, the anode 501 having one or a plurality of openings makes the voltage to be applied between the cathode 302 and the anode 501 lower than that to be applied between the cathode 302 and the anode 303 in the processing apparatus 300 according to the third embodiment. When the anode 501 is arranged at the upper portion of the chemical solution container 304', this effect becomes conspicuous. In addition, when the anode 501 is used, the number of components decreases as compared to the arrangement using the punching plate 401 described in the fourth embodiment. Hence, the apparatus can be made compact.

### [Sixth Embodiment]

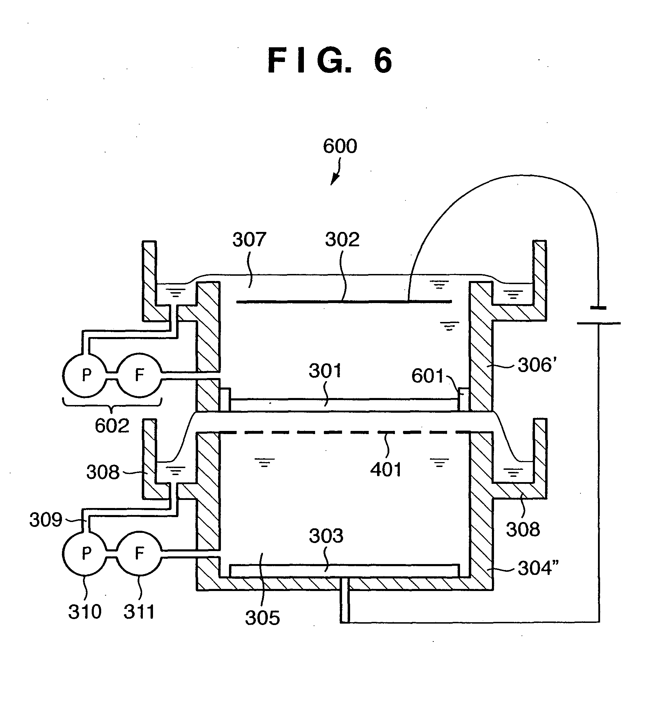

A processing apparatus according to the sixth embodiment of the present invention will be described below. Fig. 6 is a view showing the arrangement of a processing apparatus 600 according to the sixth embodiment of the present invention. The processing apparatus 600 almost has an arrangement obtained by adding some functions to that of the processing apparatus 300 according to the third embodiment. More specifically, to increase the contact area between a chemical solution 305 and the lower surface of an Si wafer 301, the processing apparatus 600 has a holding portion 601 that supports the outer peripheral wall portion of the Si wafer 301 in addition to the arrangement of the processing apparatus 300 according to the third embodiment. Various shapes can be employed as the shape of the holding portion 601. Referring to Fig. 6, the holding portion 601 is fixed on the processing apparatus 600 as a member separated from the processing apparatus 600. However, the present invention is not limited to this. For example, the holding portion 601 may be integrated with the processing apparatus 600. In this case, the cross-section of a chemical solution container 304" preferably has, at least near the Si wafer 301, almost the same diameter as that of the Si wafer 301.

In this embodiment, the holding portion 601 that supports the outer peripheral wall portion of the Si wafer 301 acts to expose most or whole part of the lower surface of the Si wafer 301. Accordingly, the contact area between the chemical solution 305 and the lower surface of the Si wafer 301 increases. The holding portion 601 can be compact as compared to a member that also holds the surface of the Si wafer 301. For this reason, the distance between a cathode 302 and an anode 303 can be reduced. When the cross-section of the chemical solution container 304" has, at least near the Si wafer 301, almost the same diameter as that of the Si wafer 301, the entire lower surface of the Si wafer 301 can be brought into contact with the chemical solution 305. The arrangement that brings the entire lower surface of the Si wafer 301 into contact with the chemical solution 305 can also be implemented by making the diameter of the cross-section of the chemical solution container 304" at least near the Si wafer 301 larger than that of the Si wafer 301. For this reason, this embodiment is not limited to the case wherein the cross-section of the chemical solution container 304" has, at least near the Si wafer 301, almost the same diameter as that of the Si wafer 301. However, if the apparatus should be designed compact, the arrangement having almost the same diameter as that of the Si wafer 301 is advantageous.

As described above, according to this embodiment, the voltage to be applied between the cathode 302 and the anode 303 can be reduced by using the holding portion 601 that holds the outer peripheral wall portion of the Si wafer 301. This effect becomes conspicuous when the cross-section of the chemical solution container 304" has, at least near the Si wafer 301, almost the same diameter as that of the Si wafer 301. The distance between the cathode 302 and the anode 303 can be reduced by the structural advantage of the holding portion 601. Hence, the voltage to be applied between the cathode 302 and the anode 303 can be lower.

As described above, according to the preferred embodiments of the present invention, the problem that the lower surface of an Si wafer cannot sufficiently be dipped in a chemical solution or failure in the chemical process due to a gas generated from the lower surface of the Si wafer 301 can be avoided, so a satisfactory chemical process can be implemented. In the preferred embodiments of the present invention, a flow forming mechanism that forms a flow of the chemical solution 305 near the lower surface of the Si wafer 301 has been described. However, the present invention is not limited to this. For example, the chemical container according to the preferred embodiments of the present invention may have a flow forming mechanism that forms a chemical solution flow near the upper surface of an Si wafer 301. For example, as shown in Fig. 6, a chemical container 306' may have a flow forming mechanism 602 (e.g., a mechanism such as a pump which moves a liquid) which forms a flow of a chemical solution 307 near the upper surface of the Si wafer 301. In this case, a gas that exists on the upper surface of the Si wafer 301 can be removed.

### [Examples]

Examples as more detailed application examples of the present invention will be described below.

### (Example 1)

An 8-inch p⁺-type Si (100) wafer serving as the substrate 101 to be processed was set at the bottom of the anodizing container 110 of the anodizing apparatus 100 shown in Fig. 1 while making the upper surface face up. The lower surface of the wafer was vacuum-chucked by the holding mechanism 111 so that the anodizing container 110 was sealed to prevent any leakage of the chemical solution.

As the process solution (chemical solution) 130, a chemical solution prepared by mixing 49% HF and ethanol at a ratio of 2 : 1 was used. The process solution 130 was injected to the main body container 110a of the anodizing container 110 by the pump 131. The process solution 130 was circulated while the overflow container 110b recovered the process solution 130 that had overflowed from the main body container 110a.

The main body container 110a had a cylindrical shape with a diameter of 202 mm. The overflow container (outer container) 110b was installed outside the main body container 110a. The anodizing container 110 (main body container 110a and overflow container 110b) was made of polytetrafluoroethylene (PTFE) that had an excellent resistance against hydrofluoric acid. The main body container 110a had, at the bottom, the openings 112 each having a diameter of 160 mm. The cathode 120 was formed from a platinum plate having a diameter of 200 mm. The cathode 120 was set almost parallel to the substrate 101 while being separated from the substrate 101 by 30 mm.

The pressure vessel (conductive solution container) 140 had a cylindrical shape with a diameter of 160 mm. The recovery container (outer container) 143 was installed outside the pressure vessel 140. As the shower head 141, a punching plate having a number of openings 142 with a diameter of 0.3 mm and an array pitch of 5 mm was employed. As the anode 150, a platinum plate having a diameter of 158 mm was set horizontally. As the conductive solution 160, a 1% aqueous HF solution was used.

When the conductive solution 160 was injected to the pressure vessel 140 by the pump 161, a shower of the conductive solution 160 was sent up through a number of openings 142 of the shower head 141 to form the liquid electrode 171 under the lower surface of the substrate 101.

In this state, a voltage was applied between the cathode 120 and the anode 150 to supply a current between them. The substrate 101 was anodized to form a porous silicon layer on the surface. A current of 3.14 A (the current density on the wafer surface side was 10 mA/cm⁻²) was supplied for 8 min. After that the pumps 131 and 161 were stopped. The chemical solution (chemical solution) 130 and the chemical solution (conductive solution 160 were recovered. Then, the substrate 101 was taken out from the anodizing container 110, cleaned, and dried.

The thickness of the porous layer formed on the surface of the substrate 101 was measured. The thickness was almost 10 µm and almost uniform on the entire surface of the substrate. This experiment was repeatedly executed for a number of substrates. Similar results were obtained for these substrates so that the reproducibility between the substrates was confirmed to be high.

### (Example 2)

The conditions were the same as in Example 1 except that 6-inch p-type Si (100) silicon substrate was employed as the anode 150. The same result as in Example 1 was obtained.

### (Example 3)

An 8-inch p⁺-type Si (100) silicon substrate was employed as the anode 150. The anodizing apparatus 200 shown in Fig. 2 was employed. The diameter of the pressure vessel (conductive solution container) 140 was 200 mm. The substrate 101 to be processed was held at only its edge portion by the edge holding mechanism 113. With this modification, the distance between the pressure vessel 140 and the anodizing container 110 could be decreased. Hence, the voltage applied between the cathode 120 and the anode 150 could be made lower than those in Examples 1 and 2. In addition, since almost the entire lower surface of the substrate 101 came into contact with the conductive solution 160 (liquid electrode 171), the film thickness uniformity of the resultant porous silicon layer further increased.

### (Example 4)

The processing apparatus of Example 4 of the present invention is shown in Fig. 3. Fig. 3 corresponds to the processing apparatus 300 according to the third embodiment.

As the processing apparatus 300 in Fig. 3, a flat liquid contact sheet processing apparatus was used. The processing apparatus 300 is constituted by the chemical container 306 arranged on the upper surface side of the Si wafer 301 and the conductive solution container 304 that brings the chemical solution into contact with the lower surface of the Si wafer 301. The 8-inch p⁺-type Si (100) wafer 301 as an object to be processed was set in the chemical container 306 while making,the upper surface face up. The lower surface of the Si wafer 301 was sealed by vacuum suction to prevent any leakage of the chemical solution. As the chemical solution 307, a chemical solution mixture containing 49% HF and ethanol at 2 : 1 was used. The chemical container 306 had a cylindrical shape with a diameter of 202 mm. The overflow container 308 was installed outside the chemical container 306. The chemical solution 307 was injected to the chemical container 306 by using the pump 310. The chemical solution 307 was circulated using the overflow container 308. The chemical container 306 was made of polytetrafluoroethylene (PTFE) that had an excellent resistance against hydrofluoric acid. In the chemical container 306, a platinum plate having a diameter of 200 mm serving as the cathode 302 was set almost parallel to the cathode 302 while being separated from the Si wafer 301 by 30 mm. The chemical container 306 has an opening with a diameter of 174 mm under the lower surface of the Si wafer 301.

The conductive solution container 304 had a cylindrical shape with an inner diameter of 154 mm. The overflow container 308 was installed outside the conductive solution container 304. A platinum plate with a diameter of 150 mm was horizontally set at the lower portion of the conductive solution container to serve as an anode. As the conductive solution 305, a 1% aqueous HF solution was used. When the conductive solution 305 was continuously supplied to the conductive solution container 304 by the pump 310, the conductive solution 305 overflowed from the opening so that the level of the conductive solution 305 was higher than the upper edge of the conductive solution container 304. The raised level and the lower surface of the 8-inch Si wafer 301 as a member to be processed were brought into almost uniform contact with each other. While maintaining this state, a voltage was applied between the anode 303 and the cathode 302 to form porous silicon. A current of 3.14 A (the current density on the surface side of the Si wafer 301 was 10 mA/cm⁻²) was supplied for 8 min. After that the pump 310 was stopped. The chemical solutions such as the chemical solution 307 and conductive solution 305 were recovered. The Si wafer 301 was cleaned and dried. The thickness of the porous layer formed on the Si wafer 301 was measured. The thickness was almost 10 µ m and uniform on the entire surface of the Si wafer 301.

In the above way, a satisfactory porous layer could be formed on the entire surface of the Si wafer 301 by the flat liquid contact sheet processing apparatus.

### (Example 5)

The processing apparatus of Example 5 of the present invention is shown in Fig. 4. Fig. 4 corresponds to the processing apparatus 400 according to the fourth embodiment. In Example 5, a punching plate 401 having a number of holes having an opening diameter of 10 mm and a pitch of 20 mm was arranged at the upper portion of the conductive solution container 304.

### (Example 6)

The processing apparatus of Example 6 of the present invention is shown in Fig. 5. Fig. 5 corresponds to the processing apparatus 500 according to the fifth embodiment. In Example 6, an anode 501 formed from a platinum plate was used as the punching plate 401 in Example 5.

### (Example 7)

The processing apparatus of Example 7 of the present invention is shown in Fig. 6. Fig. 6 corresponds to the processing apparatus 600 according to the sixth embodiment. In Example 7, an 8-inch p⁺-type Si (100) 301 was used as the anode 303. The 8-inch Si wafer 301 to be processed was held almost at only its edge. The conductive solution container 304" had a diameter of 200 mm. With this improvement, since the distance between the conductive solution container 304" and the chemical container 306' could be reduced, the voltage to be applied between the anode 303 and the cathode 302 could be made low. In addition, since the most part of the lower surface of the Si wafer 301 could come into contact with the conductive solution 305, the film thickness uniformity of porous silicon further increased.

### [Application Example]

A semiconductor substrate manufacturing method as an application example of the above-described porous layer formation by anodizing will be described next.

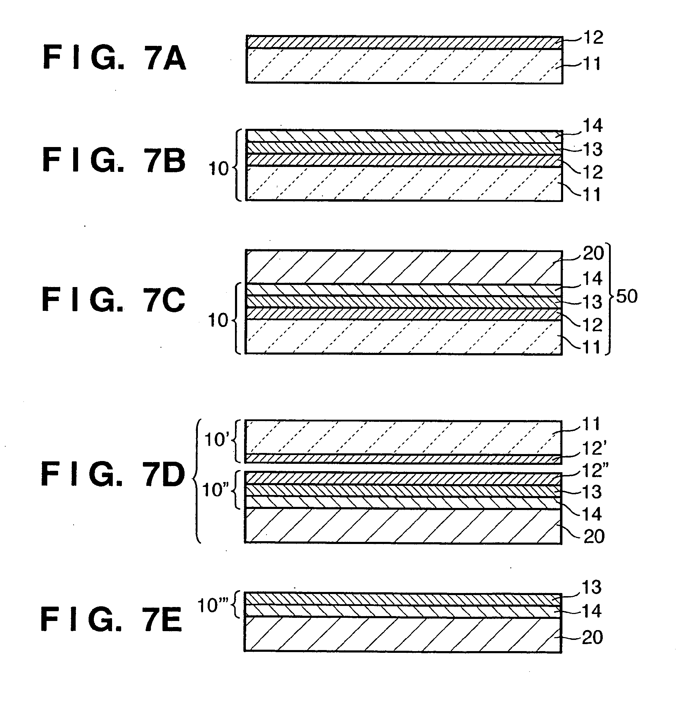

Figs. 7A to 7E are views for explaining a semiconductor substrate manufacturing method according to a preferred embodiment of the present invention.

In the step shown in Fig. 7A, a single-crystal Si substrate 11 to be used to form a first substrate (seed wafer) 10 is prepared. A porous Si layer 12 serving as a separation layer is formed on the major surface of the single-crystal Si substrate 11 by using the above-described anodizing apparatus 100, 200, 300, 400, 500, or 600. As an electrolyte, for example, a solution containing hydrogen fluoride, a solution containing hydrogen fluoride and ethanol, a solution containing hydrogen fluoride and isopropyl alcohol, or the like is preferably used. More specifically, as the electrolyte, for example, a solution mixture containing an aqueous HF solution (HF concentration = 49 wt%) and ethanol at a volume ratio of 2 : 1 is preferably used.

The porous Si layer 12 may have a multilayered structure including two or more layers with different porosities. The porous Si layer 12 having a multilayered structure preferably includes a first porous Si layer with a first porosity on the upper surface side, and, under the first porous Si layer, a second porous Si layer with a second porosity higher than the first porosity. With such a multilayered structure, a non-porous layer 13 free from defects can be formed on the first porous Si layer in the step of forming the non-porous layer 13 later. In addition, a bonded substrate stack (connected substrate) can be separated at a desired position in the separation step later. The first porosity is preferably 10% to 30% and, more preferably, 15% to 25%. The second porosity is preferably 35% to 70% and, more preferably, 40% to 60%.

When the above-described solution mixture (49 wt% hydrofluoric acid: ethanol = 2 : 1) is used as the electrolyte, preferably, for example, the first layer (surface side) is formed at a current density of 8 mA/cm² for a process time of 5 to 11 min, and the second layer (inner surface side) is formed at a current density of 23 to 33 mA/cm² for a process time of 80 sec to 2 min.

Next, at least one of the following steps (1) to (4) is preferably executed. The steps (1) and (2) are preferably executed in this order. More preferably, the steps (1), (2), and (3), or (1), (2), and (4) are executed in this order. Most preferably, the steps (1), (2), (3), and (4) are executed in this order.

### (1) Step of forming protective film on pore walls in porous Si layer (pre-oxidation step)

In this step, a protective film such as an oxide film or nitride film is formed on the pore walls in the porous Si layer 12, thereby preventing any increase in pore size by subsequent annealing. The protective film can be formed by, e.g., performing annealing in an oxygen atmosphere (preferably at, e.g., 200°C to 700°C, and more preferably, at 300°C to 500°C). After that, the oxide film or the like formed on the surface of the porous Si layer 12 is preferably removed. This can be done by, e.g., exposing the surface of the porous Si layer 12 to a solution containing hydrofluoric acid.

### (2) Hydrogen baking step (pre-baking step)

In this step, the first substrate 10 on which the porous Si layer 12 is formed is annealed in a reduction atmosphere containing hydrogen at 800°C to 1,200°C. With this annealing, pores on the surface of the porous Si layer 12 can be sealed to some extent. If a native oxide film is present on the surface of the porous Si layer 12, it can be removed.

### (3) Trace material supply step (pre-injection step)

When the non-porous layer 13 is to be grown on the porous Si layer 12, it is preferably grown at a low speed by supplying a trace amount of raw material substance of the non-porous layer 13 at the initial stage of growth. With this growing method, atomic migration on the surface of the porous Si layer 12 is promoted, and pores on the surface of this porous Si layer 12 can be sealed. More specifically, the supply of the raw material is controlled such that the growth rate becomes 20 nm/min or less, preferably, 10 nm/min or less, and more preferably, 2 nm/min or less.

### (4) High-temperature baking step (intermediate baking step)

When annealing is executed in a reduction atmosphere containing hydrogen at a temperature higher than that in the above-described hydrogen baking step and/or trace material supply step, further sealing and flattening of the porous Si layer 12 can be realized.

At the first stage of the step shown in Fig. 7B, the first non-porous layer 13 is formed on the porous Si layer 12. As the first non-porous layer 13, an Si layer such as a single-crystal Si layer, poly-Si layer, or amorphous Si layer, Ge layer, SiGe layer, SiC layer, C layer, GaAs layer, GaN layer, AlGaAs layer, InGaAs layer, InP layer, or InAs layer is preferably used.

At the second stage of the step shown in Fig. 7B, an SiO₂ layer (insulating layer) 14 serving as the second non-porous layer is formed on the first non-porous layer 13. With this process, the first substrate 10 is obtained. The SiO₂ layer 14 can be formed, e.g., in an O₂/H₂ atmosphere at 1,100°C for 10 to 33 min.

In the step shown in Fig. 7C, a second substrate (handle wafer) 20 is prepared and bonded to the first substrate 10 at room temperature while making the insulating layer 14 face the second substrate 20, thereby preparing a bonded substrate stack (connected substrate) 30.

The insulating layer 14 may be formed either on the side of the single-crystal Si layer 13, or on the second substrate 20, or on both the single-crystal Si layer 13 and the second substrate 20 as long as the state shown in Fig. 7C is obtained when the first and second substrates are bonded. However, when the insulating layer 14 is formed on the side of the first non-porous layer (e.g., a single-crystal Si layer) 13 serving as an active layer, as described above, the bonding interface between the first substrate 10 and the second substrate 20 can be separated from the active layer. Hence, a semiconductor substrate such as an SOI substrate with a higher quality can be obtained.

After the substrates 10 and 20 are completely bonded, a process for strengthening bonding between the substrates is preferably executed. As an example of this process, a process for, e.g., 1) executing annealing in an N₂ atmosphere at 1,100°C for 10 min and 2) executing annealing (oxidation) in an O₂/H₂ atmosphere at 1,100°C for 50 to 100 min is preferably performed. In addition to or instead of this process, anodic bonding and/or compression may be executed.

As the second substrate 20, an Si substrate, a substrate obtained by forming an SiO₂ layer on an Si substrate, a transparent substrate such as a silica substrate, or a sapphire substrate is preferably used. However, any other substrate may be used because the second substrate 20 only needs to have a sufficiently flat surface to be bonded (connected).

In the step shown in Fig. 7D, the bonded substrate stack (connected substrate) 30 is separated at the porous layer 12 having a low mechanical strength. Various separation methods can be employed as the separation method. A method using a fluid is preferably used. For example, a fluid is injected to the porous layer 12, or a static pressure is applied to the porous layer 12 by a fluid.

With this separation step, the transfer layer (the non-porous layer 13 and insulating layer 14) of the first substrate 10 is transferred to the second substrate 20. When only the non-porous layer 13 is formed on the porous layer 12 of the first substrate 10, the transfer layer includes only the non-porous layer 13.

In the step shown in Fig. 7E, a porous layer 12" on the second substrate 20 after separation is selectively removed by etching. In this way, a substrate which has the non-porous layer 13 on the insulating layer 14 can be obtained. When the non-porous layer 13 is, e.g., a semiconductor layer, it is called an SOI (Semiconductor On Insulator) layer. A substrate having such an SOI layer is called an SOI substrate.

In addition, a porous 12' on the single-crystal Si substrate 11 of a first substrate 10' after separation is selectively removed by etching. The single-crystal Si substrate 11 thus obtained can be reused again as a substrate to form the first substrate 10 or as the second substrate 20.

According to the present invention, a processing apparatus can be provided, which, e.g., hardly causes any damage such as flaws or the like of a substrate, reduces process failure due to bubbles, and can suitably be used for an application example in which a substrate is processed horizontally.

As many apparently widely different embodiments of the present invention can be made without departing from the spirit and scope thereof, it is to be understood that the invention is not limited to the specific embodiments thereof except as defined in the claims.

Openings are formed at the bottom of an anodizing container. A shower-type current path forming mechanism is arranged at the lower portion of the anodizing container. The mechanism has a pressure vessel. A shower head is arranged at the upper portion of the pressure vessel. A conductive solution in a shower form is injected or discharged from the shower head to form a liquid electrode under the lower surface of a substrate. Accordingly, a current flows between a cathode and an anode to anodize the substrate. The apparatus also has a mechanism which makes a chemical solution overflow from a chemical solution container to form a flow of the chemical solution near the lower surface of the substrate.

## Claims

1. A processing apparatus which has a first electrode and a second electrode, arranges a substrate between the first and second electrodes, and supplies a current between the first and second electrodes through a chemical solution and the substrate to process the substrate, comprising:
a shower head which is arranged between the first electrode and the substrate to form a chemical solution flow in a shower form toward the substrate,
wherein the chemical solution flow in the shower form formed by said shower head forms part of a current path between the first and second electrodes.

2. The apparatus according to claim 1, further comprising another shower head which is arranged between the second electrode and the substrate to form a chemical solution flow in a shower form toward the substrate.

3. The apparatus according to claim 1, wherein said shower head has a member having a plurality of openings, and the chemical solution in the shower form is injected or discharged through the plurality of openings.

4. The apparatus according to claim 3, wherein a surface of the member, which has the plurality of openings, is arranged substantially parallel to the substrate.

5. The apparatus according to claim 1, further comprising a circulation mechanism which recovers the chemical solution injected or discharged from said shower head and supplies the chemical solution again to said shower head.

6. A processing method of arranging a substrate between a first electrode and a second electrode and supplying a current between the first and second electrodes through a chemical solution and the substrate to process the substrate, comprising a step of:
arranging a shower head at least at one of a position between the first electrode and the substrate and a position between the second electrode and the substrate, causing the shower head to form a chemical solution flow in a shower form toward the substrate, and causing the chemical solution flow in the shower form to form part of a current path between the first and second electrodes.

7. An anodizing method of arranging a substrate between a first electrode and a second electrode and supplying a current between the first and second electrodes through a chemical solution and the substrate to anodize the substrate, comprising a step of:
arranging a shower head at least at one of a position between the first electrode and the substrate and a position between the second electrode and the substrate, causing the shower head to form a chemical solution flow in a shower form toward the substrate, and causing the chemical solution flow in the shower form to form part of a current path between the first and second electrodes.

8. A processing apparatus which has a first electrode arranged above a substrate to oppose the substrate and a second electrode arranged under the substrate to oppose the substrate and executes a chemical process for the substrate, comprising:
a chemical solution container which fills a space between the substrate and the second electrode with a chemical solution; and
a mechanism which forms a flow of the chemical solution near a lower surface of the substrate,
wherein said mechanism has a function of causing the chemical solution to overflow from said chemical solution container.

9. The apparatus according to claim 8, wherein said chemical solution container is configured to bring the chemical solution into contact with the lower surface of the substrate.

10. The apparatus according to claim 8, wherein said chemical solution container has a plate which has one or a plurality of openings and opposes the substrate, and the chemical solution flows toward the substrate through the openings of the plate.

11. The apparatus according to claim 10, wherein the plate is arranged at an upper portion of said chemical solution container.

12. The apparatus according to claim 8, wherein the second electrode has one or a plurality of openings, and the chemical solution flows toward the substrate through the openings of the second electrode.

13. The apparatus according to claim 12, wherein the second electrode having the openings is arranged at an upper portion of said chemical solution container.

14. The apparatus according to claim 8, further comprising a holding portion which supports an outer peripheral wall portion of the substrate.

15. The apparatus according to claim 8, wherein a diameter of a cross-section of said chemical solution container near the substrate is substantially the same as that of the substrate.

16. The apparatus according to claim 8, wherein said chemical solution container has an overflow container to be filled with the chemical solution on an outer side thereof.

17. A semiconductor substrate manufacturing method comprising steps of:
anodizing a first substrate in accordance with an anodizing method of claim 7 to form a porous layer;
forming a non-porous layer on the porous layer;
bonding the first substrate having the non-porous layer to a second substrate via an insulating layer to prepare a bonded substrate stack; and
processing or fabricating the bonded substrate stack to obtain a state in which the porous layer at least partially remains on the second substrate.

18. A semiconductor substrate manufacturing method comprising steps of:
anodizing a first substrate by using a processing apparatus of claim 8 to form a porous layer;
forming a non-porous layer on the porous layer;
bonding the first substrate having the non-porous layer to a second substrate via an insulating layer to prepare a bonded substrate stack; and
processing or fabricating the bonded substrate stack to obtain a state in which the porous layer at least partially remains on the second substrate.
